# EUROPEAN PATENT APPLICATION

(11) **EP 4 460 157 A1**
(43) Date of publication of application: **06.11.2024**
(21) Application number: 22915992.6
(22) Date of filing: 26.12.2022
(51) Int. Cl.: H05K 3/46

(54) **MULTILAYER SUBSTRATE AND JIG**

(30) Priority: 28.12.2021 JP 2021214466
(71) Applicant: Nidec Advance Technology Corporation, Muko-shi, Kyoto 617-0003 (JP)
(72) Inventor: SAKAI, Shigeki, Muko-shi, Kyoto 617-0003 (JP); KIMURA, Kazuo, Muko-shi, Kyoto 617-0003 (JP); YAGI, Masanobu, Muko-shi, Kyoto 617-0003 (JP)
(74) Representative: Viering, Jentschura & Partner mbB Patent- und Rechtsanwälte
(86) International application number: PCT/JP2022/047811
(87) International publication number: WO 2023/127769

(57) **Abstract**

A pitch conversion module 2 includes a plurality of double-sided substrates DS including a first metal pattern MP1 formed on an upper surface, a second metal pattern MP2 formed on a lower surface, and a metal via MV connecting the first metal pattern MP1 and the second metal pattern MP2, and a first conductive paste via CV1 formed of conductive paste connecting the first metal pattern MP1 and the second metal pattern MP2 between the double-sided substrates DS adjacent to each other in a double-sided substrate block DSB in which a plurality of the double-sided substrates DS are stacked.

## Description

### TECHNICAL FIELD

The present invention relates to a multilayer substrate and a jig using the multilayer substrate.

### BACKGROUND ART

Conventionally, a multilayer substrate, what is called a build-up substrate, manufactured by repeating photolithography processing including photoresist film formation, development, conductor formation, and the like has been known (see, for example, Patent Literature 1).

### CITATIONS LIST

### PATENT LITERATURE

Patent Literature 1: JP 2001-36236 A

### SUMMARY OF INVENTION

### TECHNICAL PROBLEMS

For the above-described build-up substrate, the above-described photolithography processing needs to be repeated each time the number of layers is further increased. For this reason, when the number of layers increases, manufacturing time of a multilayer substrate becomes long substantially in proportion to the number of layers.

An object of the present invention is to provide a multilayer substrate for which manufacturing time can be easily shortened, and a jig using the multilayer substrate.

### SOLUTIONS TO PROBLEMS

A multilayer substrate according to an example of the present invention includes a plurality of double-sided substrates including a first metal pattern formed on one surface, a second metal pattern formed on another surface, and a metal via connecting the first and second metal patterns, and a first conductive paste via formed of conductive paste that connects the first metal pattern and the second metal pattern between the double-sided substrates adjacent to each other in a double-sided substrate block in which a plurality of the double-sided substrates are stacked. A conductive path is formed from the first metal pattern in the double-sided substrate on the one side of a pair of the double-sided substrates adjacent to each other to the second metal pattern via the metal via, the second metal pattern, the first conductive paste via, the first metal pattern in a double-sided substrate on another side, and the metal via.

Further, a multilayer substrate according to an example of the present invention includes three or more double-sided substrates including a first metal pattern formed on one surface, a second metal pattern formed on another surface, and a metal via connecting the first and second metal patterns, in a double-sided substrate block in which the three or more double-sided substrates are stacked, a first conductive paste via formed of conductive paste that connects the first metal pattern and the second metal pattern between a pair of the double-sided substrates adjacent to each other, and a fourth conductive paste via formed of conductive paste that connects the second metal pattern of a double-sided substrate on the another side of the pair of double-sided substrates and a first metal pattern of a double-sided substrate adjacent to the another side of a double-sided substrate including the second metal pattern.

Further, a jig according to an example of the present invention includes the multilayer substrate described above, and a contact that can come into contact with an inspection object to perform electrical inspection. The contact and the multilayer substrate are electrically connected.

### ADVANTAGEOUS EFFECTS OF INVENTION

For a multilayer substrate having such a configuration and an inspection device using the multilayer substrate, manufacturing time can be easily shortened as compared with a build-up substrate.

### BRIEF DESCRIPTION OF DRAWINGS

FIG. 1 is an explanatory view conceptually illustrating an example of a configuration of an inspection device using a jig according to an embodiment of the present invention.
FIG. 2 is a cross-sectional view of a pitch conversion module 2 illustrated in FIG. 1 taken along a vertical direction.
FIG. 3 is a flowchart mainly illustrating an example of a method of manufacturing a double-sided substrate DS.
FIG. 4 is a flowchart mainly illustrating an example of a method of manufacturing a first multilayer substrate ML1 and a second multilayer substrate ML2 and assembling the pitch conversion module 2.

### DESCRIPTION OF EMBODIMENT

Hereinafter, an embodiment of the present invention will be described below with reference to drawings. Note that configurations with the same reference numerals in the drawings indicate the same configurations and are omitted from description. In each diagram, a vertical direction is appropriately illustrated to indicate a direction. An upper side corresponds to an example of one side, and a lower side corresponds to an example of another side. Note that the vertical direction is illustrated for convenience of description, and arrangement according to the present invention is not limited to an illustrated direction.

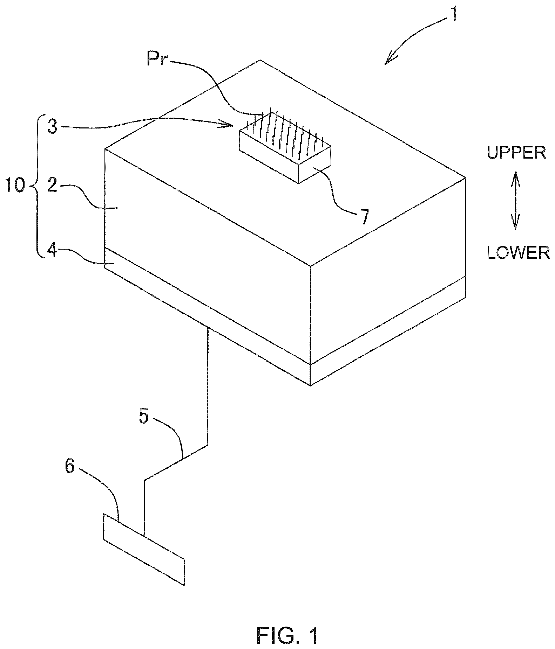

The inspection device 1 illustrated in FIG. 1 roughly includes an inspection jig 10 (jig), a connection member 5, and an inspection unit 6. The inspection jig 10 includes a jig head 3, a pitch conversion module 2 (multilayer substrate), and a connection plate 4. The pitch conversion module 2 corresponds to an example of a multilayer substrate.

The jig head 3 includes a plurality of contacts Pr and a holding member 7 that holds a plurality of the contacts Pr. An inspection object (not illustrated) is placed on the jig head 3. A plurality of the contacts Pr are in contact with and conductive to an inspection point of an inspection object placed on the jig head 3.

The inspection object may be, for example, a substrate or a member such as a printed circuit board, a flexible board, a ceramic multilayer circuit board, an electrode plate for use in a liquid crystal display or a plasma display, a semiconductor substrate, a semiconductor wafer, a package board for use in a semiconductor package, and a film carrier. Further, the inspection object may be, for example, an electronic component such as a semiconductor device (integrated circuit (IC)), or any other objects subject to an electric inspection.

The pitch conversion module 2 is arranged between the jig head 3 and the connection plate 4. On an upper surface of the pitch conversion module 2, a plurality of third metal patterns MP3 in contact with a rear end of the contacts Pr are formed. A plurality of seventh metal patterns MP7 conductive to the third metal patterns MP3 are formed on a lower surface of the pitch conversion module 2.

A plurality of electrodes in contact with the seventh metal patterns MP7 are formed on an upper surface of the connection plate 4. Each electrode of the connection plate 4 and the inspection unit 6 are electrically connected by the connection member 5 such as a cable. By the above, an inspection point of an inspection object and the inspection unit 6 are electrically connected.

The inspection unit 6 electrically inspects insulation, short circuit, a resistance value, a capacitance value, or the like between inspection points of an inspection object via the jig head 3, the pitch conversion module 2, the connection plate 4, and the connection member 5.

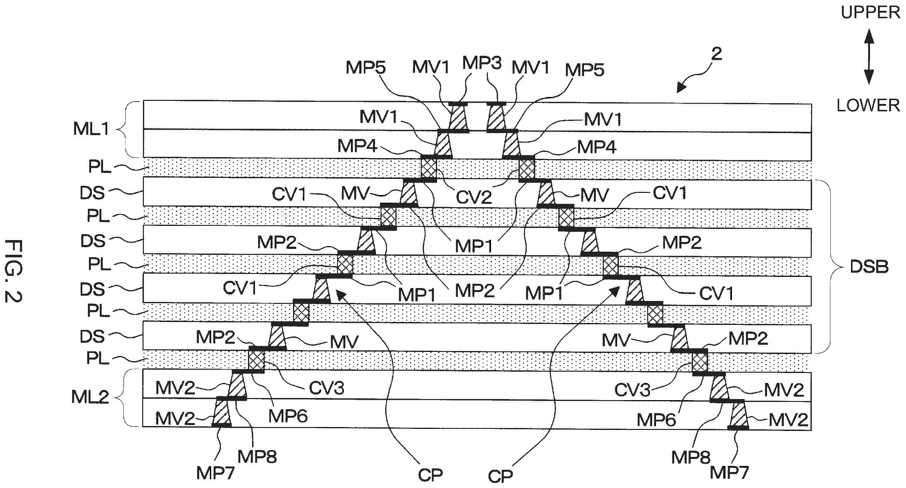

As illustrated in FIG. 2, the pitch conversion module 2 roughly has a structure in which a first multilayer substrate ML1, a double-sided substrate block DSB, and a second multilayer substrate ML2 are stacked.

The double-sided substrate block DSB has a structure in which a plurality of double-sided substrates DS are stacked. The double-sided substrate DS includes a first metal pattern MP1 formed on an upper surface (one surface), a second metal pattern MP2 formed on a lower surface (another surface), and a metal via MV connecting the first metal pattern MP1 and the second metal pattern MP2.

In the double-sided substrate block DSB, a first conductive paste via CV1 that connects the second metal pattern MP2 on one side and the first metal pattern MP1 on another side between adjacent ones of the double-sided substrates DS is formed.

By the above, a plurality of conductive paths CP are formed from the first metal pattern MP1 in the double-sided substrate DS on the upper side of a pair of adjacent double-sided substrates to the second metal pattern MP2 via the metal via MV, the second metal pattern MP2, the first conductive paste via CV1, the first metal pattern MP1 in the double-sided substrate DS on the lower side, and the metal via MV.

The first conductive paste via CV1 connecting the second metal pattern MP2 of the double-sided substrate DS second from the top and the first metal pattern MP1 of the double-sided substrate DS third from the top in the double-sided substrate block DSB corresponds to an example of a fourth conductive paste via.

As a result, the conductive path CP is formed from the first metal pattern MP1 on the uppermost side in the double-sided substrate block DSB, that is, on an upper surface of the double-sided substrate block DSB to the second metal pattern MP2 on the lowermost side in the double-sided substrate block DSB, that is, on a lower surface of the double-sided substrate block DSB via each of the double-sided substrates DS and a plurality of the first conductive paste vias CV1 connecting the double-sided substrates DS.

The first multilayer substrate ML1 and the second multilayer substrate ML2 are what is called a build-up substrate on which an inner layer pattern is formed. The first multilayer substrate ML1 includes the third metal pattern MP3 formed on an upper surface (one surface), a fourth metal pattern MP4 formed on a lower surface (another surface), a fifth metal pattern MP5 formed on an inner layer, and first non-penetrating metal vias MV1 connecting the third metal pattern MP3 and the fifth metal pattern MP5 and connecting the fifth metal pattern MP5 and the fourth metal pattern MP4.

The first multilayer substrate ML1 is stacked on an upper surface of the double-sided substrate block DSB, that is, the double-sided substrate DS on the uppermost side in the double-sided substrate block DSB. The fourth metal pattern MP4 of the first multilayer substrate ML1 and the first metal pattern MP1 of the double-sided substrate DS on the uppermost side are connected by a second conductive paste via CV2.

By the above, the conductive path CP extends from the third metal pattern MP3 to the second metal pattern MP2 on the lowermost side of the double-sided substrate block DSB via the first non-penetrating metal via MV1, the fifth metal pattern MP5, the first non-penetrating metal via MV1, the fourth metal pattern MP4, the second conductive paste via CV2, and the double-sided substrate block DSB.

The second multilayer substrate ML2 includes a sixth metal pattern MP6 formed on an upper surface (one surface), a seventh metal pattern MP7 formed on a lower surface (another surface), an eighth metal pattern MP8 formed in an inner layer, and a second non-penetrating metal via MV2 connecting the sixth metal pattern MP6 and the eighth metal pattern MP8 and connecting the eighth metal pattern MP8 and the seventh metal pattern MP7.

The second multilayer substrate ML2 is stacked on a lower surface of the double-sided substrate block DSB, that is, the double-sided substrate DS on the lowermost side in the double-sided substrate block DSB. The sixth metal pattern MP6 of the second multilayer substrate ML2 and the second metal pattern MP2 of the double-sided substrate DS on the lowermost side are connected by a third conductive paste via CV3.

By the above, the conductive path CP extends from the third metal pattern MP3 on an upper surface of the first multilayer substrate ML1 to the seventh metal pattern MP7 via the first non-penetrating metal via MV1, the fifth metal pattern MP5, the first non-penetrating metal via MV1, the fourth metal pattern MP4, the second conductive paste via CV2, the double-sided substrate block DSB, the third conductive paste via CV3, the sixth metal pattern MP6, the second non-penetrating metal via MV2, the eighth metal pattern MP8, and the second non-penetrating metal via MV2.

The first conductive paste via CV1, the second conductive paste via CV2, and the third conductive paste via CV3 are formed using what is called conductive paste such as transient liquid phase sintering (TLPS) paste. The first metal pattern MP1, the second metal pattern MP2, the third metal pattern MP3, the fourth metal pattern MP4, the fifth metal pattern MP5, the sixth metal pattern MP6, the seventh metal pattern MP7, the eighth metal pattern MP8, the metal via MV, the first non-penetrating metal via MV1, and the second non-penetrating metal via MV2 are formed of a metal material different from conductive paste.

Note that although the example in which the first multilayer substrate ML1 and the second multilayer substrate ML2 are three-layer substrates including one inner layer is described, the first multilayer substrate ML1 and the second multilayer substrate ML2 may be a multilayer substrate of four layers or more including two or more inner layers.

In a case where the first multilayer substrate ML1 includes two or more inner layers, the fifth metal pattern MP5 is provided for each inner layer, and the fifth metal patterns MP5 between adjacent inner layers are connected by a non-penetrating metal via. In a case where the second multilayer substrate ML2 includes two or more inner layers, the eighth metal pattern MP8 is provided for each inner layer, and the eighth metal patterns MP8 between adjacent inner layers are connected by a non-penetrating metal via. The number of layers of the first multilayer substrate ML1 and the number of layers of the second multilayer substrate ML2 are preferably the same.

An interval between the seventh metal patterns MP7 on the lowermost side in each of the conductive paths CP, that is, the side to which the connection plate 4 is attached is wider than an interval between the third metal patterns MP3 on the uppermost side in each of the conductive paths CP, that is, the side to which the jig head 3 is attached.

In recent years, a printed wiring board, a semiconductor wafer, or the like, which is an inspection object, has an extremely fine structure, and an interval between inspection points is extremely narrow. On the other hand, an arrangement interval of the contacts Pr in contact with an inspection point is substantially equal to an arrangement interval of inspection points of an inspection object. In this way, it is necessary to electrically connect the contacts Pr arranged at minute intervals to the inspection unit 6 by wiring or the like. However, a certain space or more is required to connect a wiring to the contact Pr, and it is difficult to connect a wiring at such a minute interval.

Therefore, according to the pitch conversion module 2, an interval between the seventh metal patterns MP7 on the side to which the connection plate 4 is attached is wider than an interval between the third metal patterns MP3 on the side to which the jig head 3 is attached. Therefore, by bringing a rear end of the contact Pr into contact with the third metal pattern MP3 and bringing an electrode of the connection plate 4 into contact with the seventh metal pattern MP7, an electrode interval of the connection plate 4 can be made wider than an interval of the contacts Pr. As a result, it is easy to connect the connection member 5 such as a wiring to an electrodes of the connection plate 4 having a wide interval.

Further, it is easy to make an interval between the third metal patterns MP3 of the first multilayer substrate ML1 narrower than an interval between the first metal patterns MP1 of the double-sided substrate DS. A reason for the above is as described below.

That is, the first conductive paste via CV1 is formed by printing conductive paste. For this reason, an interval between the second metal patterns MP2 in which the first conductive paste via CV1 is formed needs to be set to an interval that can be realized with processing accuracy by a printing technique. Therefore, an interval between the second metal patterns MP2 cannot be made narrower than an interval that can be allowed by processing accuracy of a printing technique. Further, the inspection jig 10 is often provided with thousands of the contacts Pr. Then, thousands of the conductive paths CP need to be formed without interference with each other.

The second metal pattern MP2 and the first metal pattern MP1 of the double-sided substrate DS are connected by the metal via MV and the first metal pattern MP1. For this reason, an interval between the first metal patterns MP1 can be narrowed only within a range in which an interval between the second metal patterns MP2 is narrowed in one stage by a length of one of the metal vias MV and the first metal pattern MP1.

On the other hand, since the second conductive paste via CV2 is formed on the fourth metal pattern MP4 of the first multilayer substrate ML1 by a printing technique, an interval between the fourth metal patterns MP4 cannot be made narrower than width that can be allowed by processing accuracy of the printing technique. However, the first multilayer substrate ML1 is a build-up substrate in which the fifth metal pattern MP5 is formed on an inner layer. For this reason, an interval between the third metal patterns MP3 can be narrowed in two stages of the first non-penetrating metal via MV1, the fifth metal pattern MP5, the first non-penetrating metal via MV1, and the third metal pattern MP3 with respect to an interval between the fourth metal patterns MP4.

Therefore, since an interval between the third metal patterns MP3 can be narrowed in two stages of the first non-penetrating metal via MV1, the fifth metal pattern MP5, the first non-penetrating metal via MV1, and the third metal pattern MP3 with respect to an interval that can be allowed by processing accuracy of the printing technique, it is easy to make an interval narrower than an interval between the first metal patterns MP1 which can be narrowed only in one stage.

Therefore, in the configuration in which the first multilayer substrate ML1 is included and a rear end of the contact Pr is brought into contact with the third metal pattern MP3, it is easy to narrow a pitch of the contact Pr as compared with a configuration in which the first multilayer substrate ML1 is not included and a rear end of the contact Pr is brought into contact with the first metal pattern MP1 of the double-sided substrate DS. When the number of layers of the first multilayer substrate ML1 is further increased, it is easy to further narrow an interval between the third metal patterns MP3.

Therefore, the pitch conversion module 2 may have a configuration of not including the first multilayer substrate ML1, but from the viewpoint of easily coping with miniaturization of an inspection object, the pitch conversion module 2 more preferably has a configuration of including the first multilayer substrate ML1.

Further, in the double-sided substrate block DSB of the pitch conversion module 2, a plurality of the double-sided substrates DS are stacked, and the double-sided substrates DS are connected to each other by the first conductive paste via CV1. According to such a configuration, it is possible to cope with a desired electrode interval by stacking the double-sided substrates DS as many as the number of layers necessary for widening an electrode interval. In order to form such a multilayer structure only by a build-up substrate, it is necessary to repeat photolithography processing such as photoresist film formation, exposure, development, conductor formation, and insulating layer formation for the number of layers. For this reason, manufacturing time becomes longer in proportion to the number of layers.

On the other hand, the double-sided substrate block DSB of the pitch conversion module 2 is configured by stacking a plurality of the double-sided substrates DS. Therefore, in a case where the number of the double-sided substrates DS is increased in order to increase an electrode interval, a plurality of double-sided substrates can be manufactured in parallel, and it is not necessary to repeat photolithography processing for the number of layers as in a case of a build-up substrate. For this reason, for the pitch conversion module 2, manufacturing time can be easily shortened.

Further, photolithography processing includes, in a processing step of the photolithography processing, a step accompanying heating such as exposure and a step not accompanying heating. For this reason, when photolithography processing is repeated for the number of layers in manufacturing of a build-up substrate, temperature changes as many as or more than the number of layers are applied to a build-up substrate. When a temperature change is applied in a manufacturing process of a build-up substrate, structural strain occurs due to a difference in thermal expansion coefficient of a material such as resin or metal constituting the build-up substrate.

For example, since the double-sided substrate block DSB illustrated in FIG. 2 has eight layers, when an attempt is made to manufacture the double-sided substrate block DSB only by a build-up substrate, thermal stress due to eight or more temperature changes is applied, strain occurs, and warpage occurs in the build-up substrate.

On the other hand, since the double-sided substrate block DSB is constituted by laminating a plurality of the double-sided substrates DS, and the double-sided substrates DS have two layers, two or more temperature changes are applied in a manufacturing process of each of the double-sided substrates DS. As a result, the number of temperature changes can be significantly reduced as compared with a case where the double-sided substrate block DSB is manufactured only by a build-up substrate. As a result, strain generated in a manufacturing process of the double-sided substrate block DSB is reduced, and warpage is reduced.

Furthermore, for the double-sided substrate block DSB, the number of layers can be increased by increasing the number of the double-sided substrates DS. In this case, if the number of layers is increased, the number of temperature changes applied in a manufacturing process of each of the double-sided substrate DS is not increased, and thus, the possibility that warpage becomes large if the number of layers is increased is reduced.

Further, although the first multilayer substrate ML1 is a build-up substrate, since the pitch conversion module 2 includes the double-sided substrate block DSB, the number of layers of the first multilayer substrate ML1 is smaller than that in a case where the entire pitch conversion module 2 is constituted only by a build-up substrate, and thus warpage of the first multilayer substrate ML1 is reduced.

Furthermore, by employing a configuration in which the upper and lower sides of the double-sided substrate block DSB are sandwiched between the first multilayer substrate ML1 and the second multilayer substrate ML2, warpage of the first multilayer substrate ML1 can be cancelled out by warpage of the second multilayer substrate ML2, and warpage of the entire pitch conversion module 2 can be reduced. If the number of layers of the first multilayer substrate ML1 and the number of layers of the second multilayer substrate ML2 are the same, accuracy of cancelling warpage of the first multilayer substrate ML1 by warpage of the second multilayer substrate ML2 is further improved.

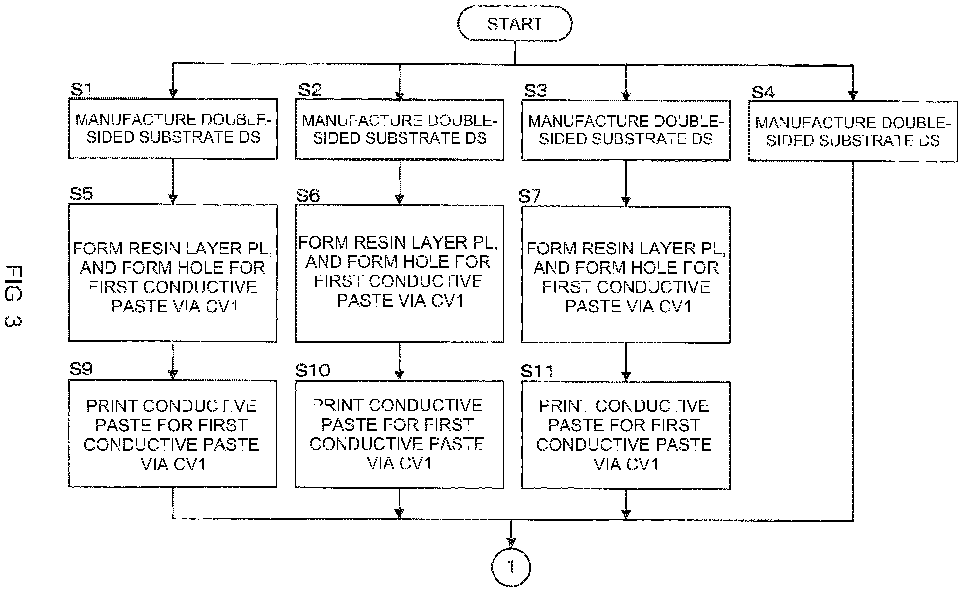

Next, an example of a method of manufacturing the pitch conversion module 2 will be described. Referring to FIG. 3, a plurality of the double-sided substrates DS are manufactured in parallel (Steps S1 to S4). In manufacturing of the double-sided substrate DS, photolithography processing is performed on two surfaces, an upper surface and a lower surface. When a plurality of the double-sided substrates DS are manufactured in parallel as in Steps S1 to S4, if the number of the double-sided substrates DS increases, it is easy to shorten manufacturing time as compared with a built-in substrate in which manufacturing time increases substantially in proportion to the number of layers.

Next, among the double-sided substrates DS manufactured in Steps S1 to S4, a resin layer PL is formed in parallel with a remaining one of the double-sided substrates DS other than the double-sided substrate DS scheduled to be arranged on the lowermost side of the double-sided substrate block DSB, and a hole for the first conductive paste via CV1 is formed on the resin layer PL (Steps S5 to S7).

Next, conductive paste is printed in parallel in the hole for the first conductive paste via CV1 of the resin layer PL (Steps S9 to S11). If formation of the resin layer PL and a hole for the first conductive paste via CV1 (Steps S5 to S7) and printing of conductive paste (Steps S9 to S11) are performed in parallel for a plurality of the double-sided substrates DS, conductive paste can be printed on all the double-sided substrates DS in processing time for one of the double-sided substrates DS if the number of the double-sided substrates DS increases, so that it is easy to shorten manufacturing time as compared with a build-up substrate in which manufacturing time increases substantially in proportion to the number of layers.

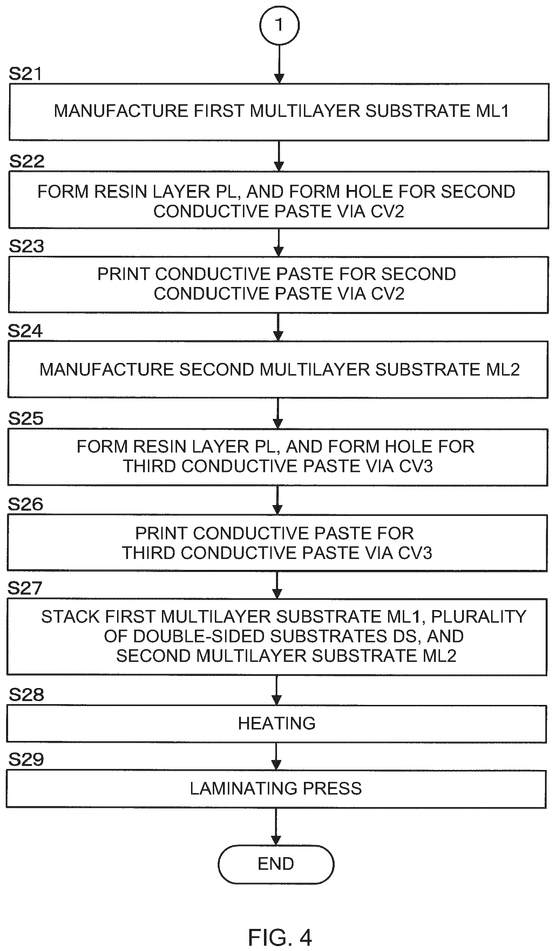

Referring to FIG. 4, the first multilayer substrate ML1 is manufactured (Step S21). Next, the resin layer PL is formed on the first multilayer substrate ML1, and a hole for the second conductive paste via CV2 is formed in the resin layer PL (Step S22). Next, conductive paste is printed in a hole for the second conductive paste via CV2 of the resin layer PL (Step S23).

Next, the second multilayer substrate ML2 is manufactured (Step S24). Next, the resin layer PL is formed on the second multilayer substrate ML2, and a hole for the third conductive paste via CV3 is formed in the resin layer PL (Step S25). Next, conductive paste is printed in the hole for the third conductive paste via CV3 of the resin layer PL (Step S26).

The first multilayer substrate ML1 and the second multilayer substrate ML2 are what is called a build-up substrate, and are manufactured by repeating photolithography processing for the number of layers. For this reason, it takes more time to manufacture than the double-sided substrate DS. However, since most of the number of layers of the entire pitch conversion module 2 can be obtained by stacking the double-sided substrates DS, it is easy to shorten manufacturing time of the entire pitch conversion module 2 by manufacturing a plurality of the double-sided substrates DS in parallel in Steps S1 to S4.

Note that Steps S21 and S24 may be executed in parallel with Steps S1 to S11. Further, Steps S22, S23, S25, and S26 may be executed in parallel with Steps S1 to S11.

Next, the first multilayer substrate ML1, a plurality of the double-sided substrates DS, and the second multilayer substrate ML2 are stacked (Step S27), heated (Step S28), and subjected to laminating press (Step S29).

By the above, substrates are welded with the resin layer PL, and conductive paste is sintered to form the first conductive paste via CV1, the second conductive paste via CV2, and the third conductive paste via CV3, so that the pitch conversion module 2 is formed.

Since the pitch conversion module 2 has a structure in which the first multilayer substrate ML1, a plurality of the double-sided substrates DS, and the second multilayer substrate ML2 are stacked, and has a structure in which substrates are connected by the first conductive paste via CV1, the second conductive paste via CV2, or the third conductive paste via CV3, the manufacturing method described in Steps S1 to S29 can be employed. As a result, it is easy to shorten manufacturing time of the pitch conversion module 2 as compared with a case where a pitch conversion module is manufactured only by a build-up substrate.

Note that the example in which formation of the resin layer PL and printing of conductive paste are not performed on the double-sided substrate DS scheduled to be arranged on the lowermost side of the double-sided substrate block DSB, and formation of the resin layer PL and printing of conductive paste are performed on the second multilayer substrate ML2 (Steps S25 and S26) is described. However, formation of the resin layer PL and printing of conductive paste may be executed on the double-sided substrate DS scheduled to be arranged on the lowermost side of the double-sided substrate block DSB, and Steps S25 and S26 do not need to be executed.

Further, the resin layer PL and print conductive paste may be performed on both surfaces of the double-sided substrate DS scheduled to be arranged on the uppermost side of the double-sided substrate block DSB, and Steps S22 and S23 do not need to be executed.

Further, the pitch conversion module 2 does not need to include the second multilayer substrate ML2 and Steps S24 to S26 do not need to be executed. If the second multilayer substrate ML2 is not included and if the first multilayer substrate ML1 is included, as described above, an effect of easily coping with miniaturization of an inspection object can be obtained.

In this case, an electrode of the connection plate 4 only needs to be brought into contact with the second metal pattern MP2 on a lower surface of the double-sided substrate block DSB. Further, an interval between the second metal patterns MP2 on the lowermost side in each of the conductive paths CP, that is, the side to which the connection plate 4 is attached is wider than an interval between the third metal patterns MP3 on the uppermost side in each of the conductive paths CP, that is, the side to which the jig head 3 is attached.

Further, the pitch conversion module 2 does not need to include the first multilayer substrate ML1 and the second multilayer substrate ML2, and Steps S21 to S26 do not need to be executed. In a case where the first multilayer substrate ML1 and the second multilayer substrate ML2 are not included, the double-sided substrate block DSB may be used as it is as the pitch conversion module 2. In this case, a rear end portion of the contact Pr only needs to be brought into contact with the first metal pattern MP1 on an upper surface of the double-sided substrate block DSB, and an electrode of the connection plate 4 only needs to be brought into contact with the second metal pattern MP2 on a lower surface of the double-sided substrate block DSB. Further, an interval between the second metal patterns MP2 on the lowermost side in each of the conductive paths CP, that is, the side to which the connection plate 4 is attached is wider than an interval between the first metal patterns MP1 on the uppermost side in each of the conductive paths CP, that is, the side to which the jig head 3 is attached.

### REFERENCE SIGNS LIST

- 1: inspection device
- 2: pitch conversion module (multilayer substrate)
- 3: jig head
- 4: connection plate
- 5: connection member
- 6: inspection unit
- 7: holding member
- 10: inspection jig (jig)
- CP: conductive path
- CV1: first conductive paste via
- CV2: second conductive paste via
- CV3: third conductive paste via
- DS: double-sided substrate
- DSB: double-sided substrate block
- ML1: first multilayer substrate
- ML2: second multilayer substrate
- MP1: first metal pattern
- MP2: second metal pattern
- MP3: third metal pattern
- MP4: fourth metal pattern
- MP5: fifth metal pattern
- MP6: sixth metal pattern
- MP7: seventh metal pattern
- MP8: eighth metal pattern
- MV: metal via
- MV1: first non-penetrating metal via
- MV2: second non-penetrating metal via
- PL: resin layer
- Pr: contact

## Claims

1. A multilayer substrate comprising:
a plurality of double-sided substrates including a first metal pattern formed on one surface, a second metal pattern formed on another surface, and a metal via connecting the first and second metal patterns; and
a first conductive paste via formed of conductive paste that connects the first metal pattern and the second metal pattern between the double-sided substrates adjacent to each other in a double-sided substrate block in which the plurality of double-sided substrates are stacked, wherein
a conductive path is formed from the first metal pattern in the double-sided substrate on the one side of a pair of the double-sided substrates adjacent to each other to the second metal pattern via the metal via, the second metal pattern, the first conductive paste via, the first metal pattern in a double-sided substrate on another side, and the metal via.

2. The multilayer substrate according to claim 1, wherein
in the double-sided substrate block, three or more of the double-sided substrates are stacked, and
a conductive path is formed from the first metal pattern furthest on the one side in the double-sided substrate block to the second metal pattern furthest on the another side in the double-sided substrate block via each of the double-sided substrates and a plurality of first conductive paste vias connecting the double-sided substrates.

3. The multilayer substrate according to claim 1 or 2, further comprising a first multilayer substrate having a third metal pattern formed on one surface, a fourth metal pattern formed on another surface, a fifth metal pattern formed on an inner layer, and first non-penetrating metal vias connecting the third metal pattern and the fifth metal pattern and connecting the fifth metal pattern and the fourth metal pattern, wherein
the first multilayer substrate is stacked on the double-sided substrate furthest on the one side in the double-sided substrate block,
the fourth metal pattern of the first multilayer substrate and the first metal pattern furthest on the one side are connected by a second conductive paste via formed of conductive paste, and
the conductive path extends from the third metal pattern to the second metal pattern furthest on the another side of the double-sided substrate block via the first non-penetrating metal via, the fifth metal pattern, the first non-penetrating metal via, the fourth metal pattern, the second conductive paste via, and the double-sided substrate block.

4. The multilayer substrate according to claim 3, further comprising a second multilayer substrate having a sixth metal pattern formed on one surface, a seventh metal pattern formed on another surface, an eighth metal pattern formed on an inner layer, and second non-penetrating metal vias connecting the sixth metal pattern and the eighth metal pattern and connecting the eighth metal pattern and the seventh metal pattern, wherein
the second multilayer substrate is stacked on the double-sided substrate furthest on the another side in the double-sided substrate block,
the sixth metal pattern of the second multilayer substrate and the second metal pattern furthest on the another side are connected by a third conductive paste via formed of conductive paste, and
the conductive path extends from the third metal pattern to the seventh metal pattern via the first non-penetrating metal via, the fifth metal pattern, the first non-penetrating metal via, the fourth metal pattern, the second conductive paste via, the double-sided substrate block, the third conductive paste via, the sixth metal pattern, the second non-penetrating metal via, the eighth metal pattern, and the second non-penetrating metal via.

5. The multilayer substrate according to any one of claims 1 to 4, the multilayer substrate being a pitch conversion module that includes a plurality of the conductive paths insulated from each other, wherein an interval between the second metal patterns furthest on the another side in each of the conductive paths is wider than an interval between the first metal patterns furthest on the one side in each of the conductive paths.

6. A multilayer substrate comprising:
three or more double-sided substrates including a first metal pattern formed on one surface, a second metal pattern formed on another surface, and a metal via connecting the first and second metal patterns;
in a double-sided substrate block in which the three or more double-sided substrates are stacked,
a first conductive paste via formed of conductive paste that connects the first metal pattern and the second metal pattern between a pair of the double-sided substrates adjacent to each other; and
a fourth conductive paste via formed of conductive paste that connects the second metal pattern of a double-sided substrate on the another side of the pair of double-sided substrates and a first metal pattern of a double-sided substrate adjacent to the another side of a double-sided substrate including the second metal pattern.

7. A jig comprising:
the multilayer substrate according to any one of claims 1 to 6; and
a contact that can come into contact with an inspection object to perform electrical inspection, wherein
the contact and the multilayer substrate are electrically connected.
